# EUROPEAN PATENT APPLICATION

(11) **EP 2 434 004 A1**
(43) Date of publication of application: **28.03.2012**
(21) Application number: 09844918.4
(22) Date of filing: 21.05.2009
(51) Int. Cl.: C11D 7/60, C11D 7/08, H01L 21/304

(54) **CLEANING LIQUID AND CLEANING METHOD**

(71) Applicant: Stella Chemifa Corporation, Osaka 541-0047 (JP)
(72) Inventor: MIYASHITA,Masayuki, Sakai-shi Osaka 590-0982 (JP); KUJIME,Takanobu, Sakai-shi Osaka 590-0982 (JP); NII,Keiichi, Sakai-shi Osaka 590-0982 (JP); YAMAMOTO,Masashi, Sakai-shi Osaka 590-0982 (JP)
(74) Representative: Sajda, Wolf E.
(86) International application number: PCT/JP2009/059371
(87) International publication number: WO 2010/134185

(57) **Abstract**

Disclosed is a cleaning liquid which is capable of cleaning an object to be cleaned, to the surface of which cerium oxide adheres, by dissolving and removing cerium oxide in the form of cerium ions. A cleaning method using the cleaning liquid is also disclosed. The cleaning liquid for removing cerium oxide is **characterized by** containing hydrogen fluoride, at least one acid selected from the group consisting of hydrochloric acid, nitric acid, sulfuric acid, acetic acid, phosphoric acid, iodic acid and hydrobromic acid, and water. The cleaning liquid is also **characterized by** dissolving and removing cerium oxide in the form of cerium ions.

## Description

### TECHNICAL FIELD

The invention relates to a cleaning liquid that makes it possible to clean and remove cerium oxide deposited on the object to be cleaned, and to a cleaning method using such a cleaning liquid.

### BACKGROUND ART

To make high-performance ultra large scale integrated circuits (ULSI), finer circuits have been designed. To form a very fine circuit structure whose size is reduced to the order of nanometers, new manufacturing techniques, which have not been used yet, are necessary in many manufacturing processes.

In particular, an exposure and development process using an optical technique is one of the most important processes for forming a fine structure on a semiconductor substrate. Uniform focusing over the surface of a semiconductor substrate so that such a fine structure can be formed is closely related to the flatness of the substrate surface.
Therefore, if the substrate surface has poor flatness, some parts of the substrate surface will be in focus, but other parts will be out of focus, so that the desired fine structure cannot be formed at the parts out of focus, which causes a large reduction in productivity. As the processing becomes finger, the tolerance for the flatness decreases, which further increases the demand for planarization of the substrate surface.

In addition to the demand for planarization, there is also a demand for a process time reduction for the purpose of improving production efficiency. Therefore, a technique capable of increasing not only the accuracy of fine processing but also the process speed is necessary. Under the technical background, chemical mechanical polishing (CMP) is generally performed as a technique to ensure flatness. In a CMP process, the surface of a semiconductor substrate is polished (planarized) at high speed using a particulate abrasive material.

Such a CMP process includes a technique using a silica slurry. In such a CMP process, the silica slurry remains as a residue, and therefore, a process of cleaning and removing the residue is performed. Examples of cleaning agents for use in the cleaning include the cleaning liquids disclosed in Patent Document 1 listed below, which are for the purpose of removing particles, organic impurities, and metal impurities. Examples also include the semiconductor substrate cleaning liquids disclosed in Patent Document 2 listed below, which are for the purpose of removing particles on a semiconductor substrate.

In a CMP process, chemical mechanical polishing with cerium oxide abrasive grains is also performed. Unfortunately, there is the problem that cerium oxide residues are difficult to remove with the above cleaning agents. Thus, this is a cause of the reduction in semiconductor device productivity.

### PRIOR ART DOCUMENTS

### Patent Documents

- Patent Document I :: Japanese Patent Application Laid-Open JP-A-2002-270 566
- Patent Document 2:: JP-A-2005-060 660.

### SUMMARY OF THE INVENTION

### PROBLEMS TO BE SOLVED BY THE INVENTION

An object of the invention is to provide a cleaning liquid that makes it possible to clean and remove cerium oxide, which is deposited on the object to be cleaned, by dissolving cerium oxide into cerium ions, and to provide a cleaning method using such a cleaning liquid.

### MEANS FOR SOLVING THE PROBLEMS

To solve the conventional problems, the inventors have made studies on cleaning liquids and cleaning methods therewith. As a result, the invention has been completed based on the finding that a cleaning liquid containing hydrogen fluoride and at least one acid selected from the group consisting of hydrochloric acid, nitric acid, sulfuric acid, acetic acid, phosphoric acid, iodic acid, and hydrobromic acid makes it possible to clean and remove cerium oxide.

Thus, to solve the above problems, the invention provides a cleaning liquid for use in removing cerium oxide, which includes: hydrogen fluoride; at least one acid selected from the group consisting of hydrochloric acid, nitric acid, sulfuric acid, acetic acid, phosphoric acid, iodic acid, and hydrobromic acid; and water, and which is capable of dissolving the cerium oxide into cerium ions when the cerium oxide is removed.

A hydrogen fluoride solution has such an oxidizing power that it can dissolve cerium oxide into cerium ions. However, dissolved cerium ions can be deposited again as impurities on the surface of the object being cleaned so that it may be difficult to remove cerium oxide. On the other hand, if the above acid is used as a cleaning liquid, it will be difficult to dissolve cerium oxide into cerium ions, and it will also be impossible to remove cerium oxide.

However, when the cleaning liquid contains a combination of hydrogen fluoride and the above acid according to the above composition, the hydrogen fluoride makes it possible for cerium oxide to be dissolved and converted into cerium ions in the cleaning liquid, and the above acid makes it possible to remove cerium oxide without re-deposition of it on the surface of the cleaned object. Thus, the cleaning liquid having the above composition makes possible cleaning and removal of cerium oxide, which have been difficult for conventional cleaning liquids.
Therefore, when the cleaning liquid of the invention is used in the cleaning of a semiconductor substrate after chemical mechanical polishing with cerium oxide abrasive grains, the cerium oxide is effectively cleaned and removed, so that the semiconductor device production efficiency is improved.

In the composition, the hydrogen fluoride preferably has a concentration in the range of 0.001 to 20 % by weight, and the acid preferably has a concentration in the range of 0.001 to 50 % by weight. When the concentration of hydrogen fluoride is set at 0.041 % by weight or more, a reduction in the ability to dissolve cerium oxide can be prevented, and when it is 20 % by weight or less, etching of the object being cleaned can be prevented.
When the concentration of the acid is set at 0.001 % by weight or more, the ability to remove cerium oxide from the object being cleaned can be ensured, and when it is 50 % by weight or less, a reduction in the ability to dissolve cerium oxide can be prevented.

To solve the above problems, the invention also provides a cleaning method using the above cleaning liquid, which includes bringing the cleaning liquid into contact with an object on which cerium oxide is deposited, so that the cerium oxide is dissolved to form cerium ions and removed.

When the cleaning liquid of the invention is brought into contact with an object on which cerium oxide is deposited, the cerium oxide can be dissolved to form cerium ions in the cleaning liquid, and the cerium oxide can be removed without being re-deposited on the surface of the object.
Thus, for example, even when a process of subjecting a semiconductor substrate to chemical mechanical polishing with cerium oxide abrasive grains is used in a semiconductor device manufacturing process, cerium oxide residues can be removed from the semiconductor substrate surface by the cleaning so that the semiconductor device productivity can be improved.

In the above method, the cleaning liquid preferably has an etch rate of 10 Å/minute or less for the object at a temperature of 25 °C. When the etch rate of the cleaning liquid used in the cleaning method of the invention is reduced to 10 Å/minute or less, etching of the object itself can be prevented. As a result, an increase in the surface roughness of the object can be suppressed when cerium oxide is removed by the cleaning.

In the above method, the cleaning liquid also preferably has a temperature of 30°C. or less during the cleaning.

In the above method, the object also preferably has undergone chemical mechanical polishing with a cerium oxide slurry.

### EFFECTS OF THE INVENTION

The invention produces the advantageous effects as described below by the means described above.
Specifically, the invention makes possible effective cleaning and removal of cerium oxide, which has been difficult with conventional acid cleaning liquids. As a result, for example, even when a CMP process with cerium oxide abrasive grains is used in a semiconductor device manufacturing process, cerium oxide residues can be removed from the semiconductor substrate by the cleaning so that the semiconductor device productivity can be improved.

### EMBODIMENTS FOR CARRYING OUT THE INVENTION

The cleaning liquid according to the invention is described below.
The cleaning liquid according to the invention includes hydrogen fluoride, at least one acid selected from the group consisting of hydrochloric acid, nitric acid, sulfuric acid, acetic acid, phosphoric acid, iodic acid, and hydrobromic acid, and water. The cleaning liquid according to the invention preferably includes any of the acids listed above as a main component.
For example, if a cleaning liquid comprising a combination of hydrogen peroxide water and the above acid is used, cerium oxide cannot be removed by cleaning with such a cleaning liquid, because cerium oxide is hardly dissolved to form cerium ions in such a cleaning liquid.
According to the invention, hydrogen fluoride is added to the cleaning liquid, so that the oxidizing power of the hydrogen fluoride makes it possible to dissolve cerium oxide and to form cerium ions in the cleaning liquid. If a cleaning liquid comprising the above acid alone is used, dissolution of cerium oxide is itself difficult, and therefore, it will be more difficult to remove cerium oxide from the object being cleaned.
However, the use of any of these acids in combination with hydrogen fluoride makes it possible not only to simply dissolve cerium ions in the cleaning liquid but also to remove cerium ions from the surface of the object being cleaned. Thus, the use of the cleaning liquid of the invention, which contains a combination of hydrogen fluoride and the above acid, makes possible cleaning and removal of cerium oxide. The term "cerium ions" means Ce³⁺, Ce⁴⁺, hydrates thereof, or complex ions thereof.

The concentration of the hydrogen fluoride is preferably in the range of 0.001 to 20 % by weight, more preferably in the range of 0.001 to 5 % by weight, based on the total weight of the cleaning liquid. If the hydrogen fluoride concentration is less than 0.001 % by weight, the ability to dissolve cerium oxide into cerium ions may be low so that the effect of cleaning cerium oxide may be undesirably low.
If the hydrogen fluoride concentration is more than 20 % by weight, the object being cleaned may be etched so that its surface roughness may increase. In addition, it may increase the cost and time required to make harmless the hydrogen fluoride in the cleaning liquid which becomes wastewater after the cleaning treatment.

Among the acids listed above, hydrochloric acid, nitric acid, sulfuric acid, or phosphoric acid is preferred in an embodiment of the invention. When these acids are used, the cleaning liquid in which cerium ions are dissolved can be easily removed without remaining on the surface of the object being cleaned.

The concentration of at least one acid selected from the group consisting of hydrochloric acid, nitric acid, sulfuric acid, acetic acid, phosphoric acid, iodic acid, and hydrobromic acid is preferably in the range of 0.001 to 50 % by weight, more preferably in the range of 0.001 to 20 % by weight, based on the total weight of the cleaning liquid. If the acid concentration is less than 0.001 % by weight, the ability to remove cerium oxide from the object being cleaned may be reduced.
On the other hand, the concentration more than 50 % by weight may increase the cost and time required to make harmless the acid in the cleaning liquid which becomes wastewater after the cleaning treatment. In addition, the volatile component may vaporize so that the cleaning liquid may change in composition, which may make it difficult to perform a stable cleaning treatment.

A surfactant may also be added to the cleaning liquid of the invention. This reduces the surface tension of the cleaning liquid to improve the wettability on the surface of the object to be cleaned. As a result, the cleaning/removing effect can be uniformly produced over a wider area on the object so that the productivity can be increased.
The surfactant is typically, but not limited to, an anionic surfactant such as an aliphatic carboxylic acid or a salt thereof. Alternatively, a nonionic surfactant such as polyethylene glycol alkyl ether or a cationic surfactant such as an aliphatic amine or a salt thereof may also be used.

The content of the surfactant is preferably in the range of 0.001 to 0.1 % by weight, more preferably in the range of 0.003 to 0.05 % by weight. The surfactant added can suppress roughening of the surface of the object being cleaned. The surfactant can also increase the wettability on the object to be cleaned so that in-plane uniformity of the cleaning effect can be achieved.
However, if the content is less than 0.001 % by weight, the reduction in the surface tension of the cleaning liquid may be insufficient so that the effect of increasing the wettability may be insufficient. If the content is more than 0.1 % by weight, not only the resulting effect may fail to be proportional to the content, but also defoaming ability may be degraded so that foam may adhere to the surface of the object being cleaned to cause uneven cleaning.

The cleaning liquid preferably has a pH value of 2 or less, more preferably a pH value of 1 or less. When the pH value is set at 2 or less, the state of dissolved cerium ions can be made stable so that the cleaning effect can be increased.

The purity and cleanliness of the cleaning liquid may be determined taking into account the manufacturing cost and the issue of the contamination of the object to undergo the cleaning treatment. For example, when the cleaning liquid of the invention is for use in an integrated circuit manufacturing process, the content of metal impurities in the cleaning liquid is preferably 0.1 ppb or less.

The method for manufacturing the cleaning liquid according to the invention is not restricted, and it may be manufacture by a known conventional method.

Next, a description is given of cleaning methods using the cleaning liquid of the invention.
For example, the object capable of being cleaned with the cleaning liquid of the invention may be, but not limited to, single crystal silicon, polycrystalline silicon, amorphous silicon, a thermal silicon oxide film, a non-doped silicate glass film, a phosphorus-doped silicate glass film, a boron-doped silicate glass film, a boron-and-phosphorus-doped silicate glass film, a TEOS film, a plasma CVD oxide film, a silicon nitride film, a silicon carbide film, a silicon oxide carbide film, or a silicon oxide carbide nitride film. The cleaning liquid may also be applied to glass, quartz, rock crystal, ceramics, etc. These materials may be used alone or in combination of two or more to form the object.

The cleaning liquid of the invention is also preferably used in cleaning an object that has been planarized by a polishing process. The surface of the object to be cleaned may be polished using any of various known conventional methods. The polishing method may be appropriately selected depending on the shape of the object to be cleaned or the desired polishing accuracy.
Specifically, for example, mechanical polishing, chemical mechanical polishing (CMP), or the like may be used, and the cleaning liquid of the invention is suitable for chemical mechanical polishing (CMP) with a cerium oxide slurry. The cerium oxide slurry is a dispersion of polishing abrasive grains of cerium oxide in a solution.

The cleaning method may be any method capable of bringing the cleaning liquid into contact with the object to be cleaned. More specifically, for example, the cleaning method may be an immersion treatment method that includes immersing an object in the cleaning liquid placed in a cleaning tank.
Alternatively, the cleaning method may be single wafer processing method that includes discharging or spraying the cleaning liquid on an object such as a silicon wafer being rotated to perform a cleaning treatment. The immersion treatment method may also be performed while an ultrasonic wave is applied to the cleaning liquid.
Alternatively, a brush scrubbing method may also be used, in which cleaning with a brush is performed while the cleaning liquid is sprayed. It will be understood that the cleaning may be performed twice or more. In this case, the composition or concentration of the cleaning liquid used may vary from one cleaning procedure to another.

The cleaning time is not restricted and may be appropriately determined depending on the degree of staining with cerium oxide deposited on the object to be cleaned. In general, the cleaning time is preferably in the range of 10 minutes or less, more preferably in the range of 3 minutes or less. If the cleaning time is more than 10 minutes, the surface of the object being cleaned may be etched so that the surface roughness may increase.

During the cleaning, the temperature of the cleaning liquid is preferably 30 °C or less, more preferably from 15 °C to 25 °C. At a temperature higher than 30 °C, the volatile component may vaporize so that the cleaning liquid may change in composition. For example, the temperature of the cleaning liquid may be controlled using a PID type temperature controller.

The cleaning liquid preferably has an etch rate of 10 Å/minute or less, more preferably 0 to 5 Å/minute, at a temperature of 25 °C. When the object being cleaned is single crystal silicon, polycrystalline silicon, or a thermal silicon oxide film, the etch rate is more preferably in the above value range. When the etch rate is set at 10 Å/minute or less, the object being cleaned can be prevented from being etched, while cerium oxide is removed by cleaning.

In the cleaning method according to the invention, if necessary, a rinsing process with a rinse agent such as ultrapure water may be performed after the cleaning treatment. This can prevent the cleaning liquid from remaining on the surface of the object cleaned.

### EXAMPLES

Hereinafter, preferred examples of the invention are illustratively described in detail. It will be understood that the materials, the amounts, and so on described in the examples are illustrative only and are not intended to limit the scope of the invention, unless otherwise specified.

### Method for Preparing Cleaning Liquid

The cleaning liquid according to each example or comparative example was prepared by appropriately adding any of the materials shown below. Specifically, the cleaning liquid was prepared by mixing in a predetermined ratio at least one of (1) 50 % by weight high-purity hydrofluoric acid (manufactured by Stella Chemifa Corporation), (2) EL grade, 36 % by weight hydrochloric acid (manufactured by Mitsubishi Chemical Corporation), (3) EL grade, 69 % by weight nitric acid (manufactured by Mitsubishi Chemical Corporation), (4) EL grade, 97 % by weight sulfuric acid (manufactured by Mitsubishi Chemical Corporation), (5) EL grade, 86 % by weight phosphoric acid (manufactured by Kishida Chemical Co., Ltd.), and (6) ultrapure water.

### Method for measuring the state of residues left on the surface of the object

TREX 610-T (manufactured by Technos Co., Ltd.) was used to measure the state of cerium oxide solid residues present on the surface of the object. The measurement was performed before and after the cleaning treatment with the cleaning liquid to determine the cleaning effect of the cleaning liquid.

### Example 1

In this example, a cleaning liquid with a hydrogen fluoride concentration of 0.1 % by weight and a hydrochloric acid concentration of 10 % by weight was prepared as shown in Table 1.

Subsequently, a 200 mm diameter silicon substrate having a TEOS film formed on its surface was subjected to chemical mechanical polishing with cerium oxide abrasive grains, and the resulting substrate was used as the object to be cleaned. The object to be cleaned was measured for the state of remaining residues, which was evaluated as described below, and as a result, about 1,000x10⁹ atoms/cm² of cerium oxide was identified as a residual component.

Subsequently, the cleaning liquid was placed in a cleaning liquid tank with a volume of 90 L, and the temperature of the cleaning liquid was adjusted to 25 °C and stabilized. The object was then immersed in the cleaning liquid tank for 1 minute, while held on a silicon substrate holding member made of PFA resin. After the immersion, the object was lifted together with the silicon substrate holding member out of the cleaning liquid tank and immersed in an ultrapure water rinse tank with a volume of 90 L, which was provided in advance, so that the cleaning liquid deposited on the surface of the object was rinsed off.
Subsequently, the object was dried and measured again for the state of remaining residues. The removal performance was evaluated as good when the amount of particulate solids was reduced to 8.5 x 10⁹ atoms/cm² or less after the treatment, and evaluated as poor when the amount of particulate solids was not reduced to 8.5 x 10⁹ atoms/cm² after the treatment. The results of the measurement of the state of remaining residues on the surface before and after the cleaning treatment with the cleaning liquid are shown in Table 1 below.

### Examples 2 to 11

In Examples 2 to 11, each cleaning liquid was prepared as in Example 1, except that the composition and concentration of the cleaning liquid were changed as shown in Table 1, The cleaning treatment with each cleaning liquid and other procedures were also performed as in Example 1. The results are shown in Table 1 below.

### Comparative Examples 1 to 9

In Comparative Examples 1 to 9, each cleaning liquid was prepared as in Example 1, except that the composition and concentration of the cleaning liquid were changed as shown in Table 1. The cleaning treatment with each cleaning liquid and other procedures were also performed as in Example 1. The results are shown in Table 1 below.

**Table 1**

| | Object surface | Hvdrofluoric acid concentration (%) | Additional acid type | Additional acid concentration (%) | Amount of particulate solids (cerium component) (x10⁹ atoms/cm²) | | Removal performance | pH |
|---|---|---|---|---|---|---|---|---|
| | | | | | Before treatment | After treatment | | |
| Examples 1 | | 0.1 | Hydrochloric acid | 10 | 4800 | <8,5 | Good | <0 |
| Example 2 | | 0.1 | Nitric acid | 10 | 5200 | <8.5 | Good | <0 |
| Example 3 | | 0.1 | Sulfuric acid | 10 | 5500 | <8.5 | Good | <0 |
| Example 4 | | 0.1 | Phosphoric acid | 10 | 4600 | <8.5 | Good | 1.7 |
| Example 5 | | 0.1 | Hydrochloric acid | 20 | 5100 | <8.5 | Good | <0 |
| Example 6 | | 0.1 | Nitric acid | 20 | 5300 | <8.5 | Good | <0 |
| Examp3e 7 | | 0.1 | Hydrochloric acid | 30 | 5400 | <8.5 | Good | <0 |
| Examples 8 | | 0.5 | Hydrochloric acid | 10 | 4800 | <8.5 | Good | <0 |
| Example 9 | | 0.5 | Nitric acid | 10 | 5200 | <8.5 | Good | <0 |
| Example 10 | | 0.5 | Sulfuric acid | 10 | 5500 | <8.5 | Good | <0 |
| Examples 11 | | 0.5 | Phosphoric acid | 10 | 4600 | <8.5 | Good | 1,6 |
| Comparative Example 1 | TEOS film | 0.1 | Absent | - | 5200 | 515 | Poor | 2.2 |
| Comparative Example 2 | | 0.5 | Absent | - | 5200 | 515 | Poor | 1.8 |
| Comparative Example 3 | | 0 | Hydrochloric acid | 10 | 4500 | 32 | Poor | <0 |
| Comparative Example 4 | | 0 | Nitric acid | 10 | 4400 | 45 | Poor | <0 |
| Comparative Example 5 | | 0 | Sulfuric acid | 10 | 5300 | 33 | Poor | <0 |
| Comparative Example 6 | | 0 | Phosphoric acid | 10 | 5700 | 60 | Poor | 1.6 |
| Comparative Example 7 | | 0 | Hydrochloric acid | 20 | 5400 | 50 | Poor | <0 |
| Comparative Example 8 | | 0 | Nitric acid | 20 | 5200 | 65 | Poor | <0 |
| Example 9 | | 0 | Hydrochloric acid | 30 | 4900 | 52 | Poor | <0 |

The results in Table 1 show that when the cleaning liquid according to each of Examples 1 to 11 was used, the amount of cerium component solids on the surface of the cleaned object was reduced to 8.5 x 10⁹ atoms/cm² or less, and therefore, the effect of cleaning and removing cerium oxide was high.

In contrast, it was demonstrated that when the cleaning liquid according to each of Comparative Examples 1 to 9 was used, the reduction in the amount of cerium component solids was small, and the effect of cleaning and removing cerium oxide was low.

### Example 12

In this example, each cleaning liquid was prepared as in Example 1, except that the composition and concentration of the cleaning liquid were changed as shown in Table 2 and that a 200 mm diameter silicon substrate having a polysilicon film formed thereon was used as the object to be cleaned. The cleaning treatment with each cleaning liquid and other procedures were also performed as in Example 1. The removal performance was evaluated as good when the amount of particulate solids was reduced to 8.5 x 10⁹ atoms/cm² or less after the treatment, and evaluated as poor when the amount of particulate solids was not reduced to 8.5 x 10⁹ atoms/cm² after the treatment. The result is shown in Table 2 below.

### Examples 13 to 22

In Examples 13 to 22, each cleaning liquid was prepared as in Example 12, except that the composition and concentration of the cleaning liquid were changed as shown in Table 2. The cleaning treatment with each cleaning liquid and other procedures were also performed as in Example 12. The results are shown in Table 2 below.

### Comparative Examples 10 to 18

In Comparative Examples 10 to 18, each cleaning liquid was prepared as in Example 12, except that the composition and concentration of the cleaning liquid were changed as shown in Table 2. The cleaning treatment with each cleaning liquid and other procedures were also performed as in Example 12. The results are shown in Table 2 below.

**Table 2**

| | Object surface | Hydrofluoric acid concentration (%) | Additional acid type | Additional acid concentration (%) | Amount of particulate solids (cerium component) (x10⁹ atoms/cm²) | | Removal performance | pH |
|---|---|---|---|---|---|---|---|---|
| | | | | | Before treatment | After treatment | | |
| Example 12 | | 0.1 | Hydrochloric acid | 10 | 4600 | <8.5 | Good | <0 |
| Example 13 | | 0.1 | Nitric acid | 10 | 5300 | <8.5 | Good | <0 |
| Example 14 | | 0.1 | Sulfuric acid | 10 | 5600 | <8.5 | Good | <0 |
| Examples 15 | | 0.1 | Phosphoric acid | 10 | 4900 | <8.5 | Good | 1.7 |
| Example 16 | | 0.1 | Hydrochloric acid | 20 | 4900 | <8.5 | Good | <0 |
| Example 17 | | 0.1 | nitric acid | 20 | 5000 | <8.5 | Good | <0 |
| Example 18 | | 0.1 | Hydrochloric acid | 30 | 6400 | <8.5 | Good | <0 |
| Example 19 | | 0.5 | Hydrochloric acid | 10 | 5800 | <8.5 | Good | <0 |
| Example 20 | | 0.5 | Nitric acid | 10 | 4800 | <8.5 | Good | <0 |
| Example 21 | Polysilicon film | 0.5 | Sulfuric acid | 10 | 6500 | <8.5 | Good | <0 |
| Example 22 | | 0.5 | Phosphoric acid | 10 | 6700 | <8.5 | Good | 1.6 |
| Comparative Example 10 | | 0.1 | Absent | - | 6600 | 6300 | Poor | 2.2 |
| Comparative Example 11 | | 0.5 | Absent | - | 4900 | 4800 | Poor | 1.8 |
| Comparative Example 12 | | 0 | Hydrochloric acid | 10 | 4800 | 4300 | Poor | <0 |
| Comparative Example 13 | | 0 | Nitric acid | 10 | 4900 | 4200 | Poor | <0 |
| Comparative Example 14 | | 0 | Sulfuric acid | 10 | 5400 | 4600 | Poor | <0 |
| Comparative Example 15 | | 0 | Phosphoric acid | 10 | 4500 | 3700 | Poor | 1.6 |
| Comparative Example 16 | | 0 | Hydrochloric acid | 20 | 5200 | 4500 | Poor | <0 |
| Comparative Examples 17 | | 0 | Nitric acid | 20 | 4900 | 4000 | Poor | <0 |
| Comparative Example 18 | | 0 | Hydrochloric acid | 30 | 5200 | 4500 | Poor | <0 |

The results in Table 2 show that when the cleaning liquid according to each of Examples 12 to 22 was used, the amount of cerium component solids on the surface of the cleaned object was reduced to 8.5 x 10⁹ atoms/cm² or less, and therefore, the effect of cleaning and removing cerium oxide was high.

In contrast, it was demonstrated that when the cleaning liquid according to each of Comparative Examples 10 to 18 was used, the reduction in the amount of cerium component solids was small, and the effect of cleaning and removing cerium oxide was low.

## Claims

1. A cleaning liquid for use in removing cerium oxide, which comprises:
hydrogen fluoride; at least one acid selected from the group consisting of hydrochloric acid, nitric acid, sulfuric acid, acetic acid, phosphoric acid, iodic acid, and hydrobromic acid; and water, and which is capable of dissolving the cerium oxide into cerium ions when the cerium oxide is removed.

2. The cleaning liquid according to claim 1,
wherein the hydrogen fluoride has a concentration in the range of 0.001 to 20 % by weight, and the acid has a concentration in the range of 0.001 to 50 % by weight.

3. The cleaning liquid according to claim 1,
which further comprises a surfactant.

4. The cleaning liquid according to claim 1,
wherein the surfactant has a content of 0.001 to 0.1 % by weight.

5. The cleaning liquid according to claim 1,
which has an etch rate of 10 Å/minute or less at a temperature of 25 °C.

6. The cleaning liquid according to claim 1,
which has a pH value of 2 or less.

7. A cleaning method using the cleaning liquid according to claim 1,
which comprises bringing the cleaning liquid into contact with an object on which cerium oxide is deposited, so that the cerium oxide is dissolved to form cerium ions and removed.

8. The cleaning method according to claim 7,
wherein the cleaning liquid has an etch rate of 10 Å/misute or less for the object at a temperature of 25 °C.

9. The cleaning method according to claim 7,
wherein the cleaning liquid has a temperature of 30 °C or less during the cleaning.

10. The cleaning method according to claim 7,
wherein the object has undergone chemical mechanical polishing with a cerium oxide slurry.
